# EUROPEAN PATENT SPECIFICATION

(11) **EP 2 016 383 B1**
(45) Date of publication and mention of the grant of the patent: **03.03.2010**
(21) Application number: 07728245.7
(22) Date of filing: 18.04.2007
(51) Int. Cl.: G01L 19/00, G10L 19/14

(54) **METHOD AND APPARATUS FOR LOSSLESS ENCODING OF A SOURCE SIGNAL USING A LOSSY ENCODED DATA STREAM AND A LOSSLESS EXTENSION DATA STREAM**
VERFAHREN UND VORRICHTUNG ZUR VERLUSTLOSEN CODIERUNG EINES QUELLENSIGNALS UNTER VERWENDUNG EINES VERLUSTBEHAFTET CODIERTEN DATENSTROMS UND EINES VERLUSTLOSEN ERWEITERUNGSDATENSTROMS
PROCEDE ET APPAREIL POUR LE CODAGE SANS PERTE D'UN SIGNAL SOURCE A L'AIDE D'UN FLUX DE DONNEES CODEES AVEC PERTE ET D'UN FLUX DE DONNEES D'EXTENSION SANS PERTE

(30) Priority: 05.05.2006 EP 06113576
(43) Date of publication of application: 21.01.2009
(73) Proprietor: Thomson Licensing, 92443 Issy-les-Moulineaux Cedex (FR)
(72) Inventor: BÖHM, Johannes, 37081 Göttingen (DE); JAX, Peter, 30171 Hannover (DE); KEILER, Florian, 30161 Hannover (DE); WÜBBOLT, Oliver, 30161 Hannover (DE); KORDON, Sven, 30173 Hannover (DE)
(74) Representative: Hartnack, Wolfgang
(86) International application number: PCT/EP2007/053783
(87) International publication number: WO 2007/128661

(56) References cited:
- DE-C1- 19 742 201
- US-A1- 2002 087 304
- US-A1- 2004 054 529
- US-B1- 6 498 811
- ADISTAMBHA K ET AL: "An Investigation into Embedded Audio Coding using An AAC Perceptually Lossless Base Layer" PROCEEDINGS OF THE AUSTRALIAN INTERNATIONAL CONFERENCE ON SPEECH SCIENCE AND TECHNOLOGY, XX, XX, 8 December 2004 (2004-12-08), pages 227-230, XP002389965
- JIN A ET AL: "Scalable audio coder based on quantizer units of MDCT coefficients" ACOUSTICS, SPEECH, AND SIGNAL PROCESSING, 1999. PROCEEDINGS., 1999 IEEE INTERNATIONAL CONFERENCE ON PHOENIX, AZ, USA 15-19 MARCH 1999, PISCATAWAY, NJ, USA,IEEE, US, vol. 2, 15 March 1999 (1999-03-15), pages 897-900, XP010328465 ISBN: 0-7803-5041-3
- JIN A ET AL: "A HIERARCHICAL LOSSLESS/LOSSY CODING SYSTEM FOR HIGH QUALITY AUDIO UP TO 192 KHZ SAMPLING 24 BIT FORMAT" IEEE TRANSACTIONS ON CONSUMER ELECTRONICS, IEEE SERVICE CENTER, NEW YORK, NY, US, vol. 49, no. 3, August 2003 (2003-08), pages 759-764, XP001172126 ISSN: 0098-3063

## Description

The invention relates to a method and to an apparatus for lossless encoding of a source signal, using a lossy encoded data stream and a lossless extension data stream which together form a lossless encoded data stream for said source signal. Lossy perceptual audio coding data are enhanced by extension data that enable mathematically exact (lossless) reproduction of the original audio signal waveform.

### Background

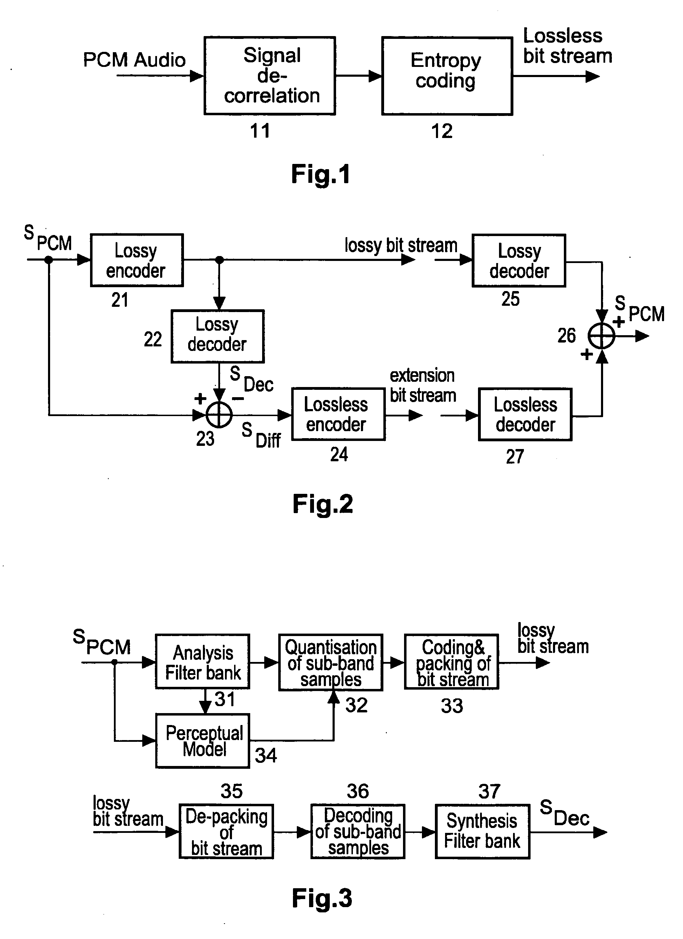

The basic principle of lossless audio coding is depicted in Fig. 1. The digital PCM Audio signal samples are not independent to each other. A signal de-correlation 11 is used to reduce this dependency before entropy coding 12. This process needs to be reversible, to be able to restore the original signal. Known de-correlation techniques are using Linear Predictive Filtering (also known as Linear Predictive Coding LPC), integer filter-banks and lossy based approaches.

The basic principle of lossy based lossless coding is depicted in Fig. 2 and Fig. 3. In the encoding part (left side) in Fig. 2, a PCM audio input signal S_{PCM} passes through a lossy encoder 21 to a lossy decoder 22 and as a lossy bit stream to a lossy decoder 25 in the decoding part (right side). Lossy encoding and decoding is used to de-correlate the signal. The output signal of decoder 22 is removed from the input signal S_{PCM} in a subtractor 23, and the resulting difference signal passes through a lossless encoder 24 as an extension bit stream to a lossless decoder 27. The output signals of the decoders 25 and 27 are combined 26 so as to regain the original signal S_{PCM}.

This basic principle is disclosed for audio coding in EP-B-0756386 and US-B-6498811, and is also discussed in P. Craven, M. Gerzon, "Lossless Coding for Audio Discs", J. Audio Eng. Soc., Vol.44, No.9, September 1996, and in J. Koller, Th. Sporer, K.H. Brandenburg, "Robust Coding of High Quality Audio Signals", AES 103rd Convention, Preprint 4621, August 1997.

In the lossy encoder in Fig. 3, the PCM audio input signal S_{PCM} passes through an analysis filter bank 31 and a quantisation 32 of sub-band samples to a coding and bit stream packing 33. The quantisation is controlled by a perceptual model calculator 34 that receives signal S_{PCM} and corresponding information from the analysis filter bank 31.
At decoder side, the encoded lossy bit stream enters a means 35 for de-packing the bit stream, followed by means 36 for decoding the subband samples and by a synthesis filter bank 37 that outputs the decoded lossy PCM signal S_{Dec}.
Examples for lossy encoding and decoding are described in detail in the standard ISO/IEC 11172-3 (MPEG-1 Audio).

Because a lossy encoder produces an error signal S_{Diff} that is proportional to the masking thresholds in the frequency domain, the signal is not very well de-correlated and therefore sub-optimum for entropy coding. As a consequence, the following publications focus on a special handling of the error signal S_{Diff}. The common approach is to apply variations of LPC de-correlation schemes to the error signal S_{Diff}: WO-A-9953677, US-A-20040044520, WO-A-2005098823. In EP-A-0905918 the amplitude of the error signal S_{Diff} is used with a feedback loop to the quantisation stage of the lossy encoder part in order to control the quantisation in the lossy encoder and thus to generate a better de-correlation of the error signal S_{Diff}.

K. ADISTAMBHA et al.: "An Investigation into Embedded Audio Coding using An AAC Perceptually Lossless Base Layer", Proceedings of the 10th Australian International Conference on Speech Science & Technology, Macquarie University, Sydney, 8-10 December 2004, pages 227-230, XP002389965, shows lossless audio encoding wherein the base layer is encoded and decoded and the residual difference signal between the original input signal and the decoded base layer signal is lossless encoded.

A. JIN et al.: "Scalable audio coder based on quantizer units of MDCT coefficients", ACOUSTICS, SPEECH, AND SIGNAL PROCESSING, 1999, PROCEEDINGS, 1999 IEEE International Conference on Phoenix, AZ, USA, 15-19 March 1999, Piscataway, NJ, USA, JEEE, US, vol.2, 15 March 1999, pages 897-900, XP010328465, and US 2004/0054529 A1 disclose scalable audio encoding wherein the different layers are generated using hierarchical quantisation of the input signal coefficients.

US 2002/0087304 A1 shows audio encoding wherein the coding quality is improved by using spectral whitening.

### Invention

When providing a lossless coding extension for lossy coding it is desirable to facilitate this in a scalable manner.

A problem to be solved by the invention is to provide an improved lossless coding/decoding extension for lossy coding/ decoding in a scalable manner, the lossy coding/decoding being based for example on mp3 (MPEG-1 Audio Layer 3). This problem is solved by the encoding method of claim 1 and the decoding method of claim 3. Apparatuses that utilise these methods are disclosed in claims 2 and 4, respectively.

The invention facilitates enhancing a lossy perceptual audio encoding/decoding by an extension that enables mathematically exact reproduction (i.e. lossless encoding/deco-ding) of the original waveform. The lossy based lossless coding makes use of enhanced de-correlation by means of spectral de-correlation build into the lossy encoder-decoder and additional temporal LPC de-correlation, where the LPC filter parameters need not be transmitted.
Advantageously, the inventive lossless extension can be used to extend the widely used mp3 encoding/decoding to lossless encoding/decoding.

Advantageous additional embodiments of the invention are disclosed in the respective dependent claims.

### Drawings

Exemplary embodiments of the invention are described with reference to the accompanying drawings, which show in:
- Fig. 1: known principle of lossless audio signal compression;
- Fig. 2: basic block diagram for a known lossy based lossless encoder and decoder;
- Fig. 3: known principle operation of a lossy encoder and a lossy decoder;
- Fig. 4: block diagram for the inventive lossy based lossless encoding;
- Fig. 5: block diagram for the inventive lossy based lossless decoding;
- Fig. 6: more detailed block diagram for the lossy encoder in Fig. 4;
- Fig. 7: example signals:
a) discrete signal spectrum in lossy encoder sub-band domain,
b) error signal following perceptually controlled quantisation,
c) error signal following whitening,
d) spectral noise shaping to adapt to a given LPC filter signal ;
- Fig. 8: more detailed block diagram for the lossy decoder in Fig. 5;
- Fig. 9: more detailed block diagram for the lossless encoder and packer in Fig. 4;
- Fig. 10: LPC de-correlator;
- Fig. 11: more detailed block diagram for the lossless de-packer and decoder in Fig. 5;
- Fig. 12: extension file structure;
- Fig. 13: bit stream formatting.

### Exemplary embodiments

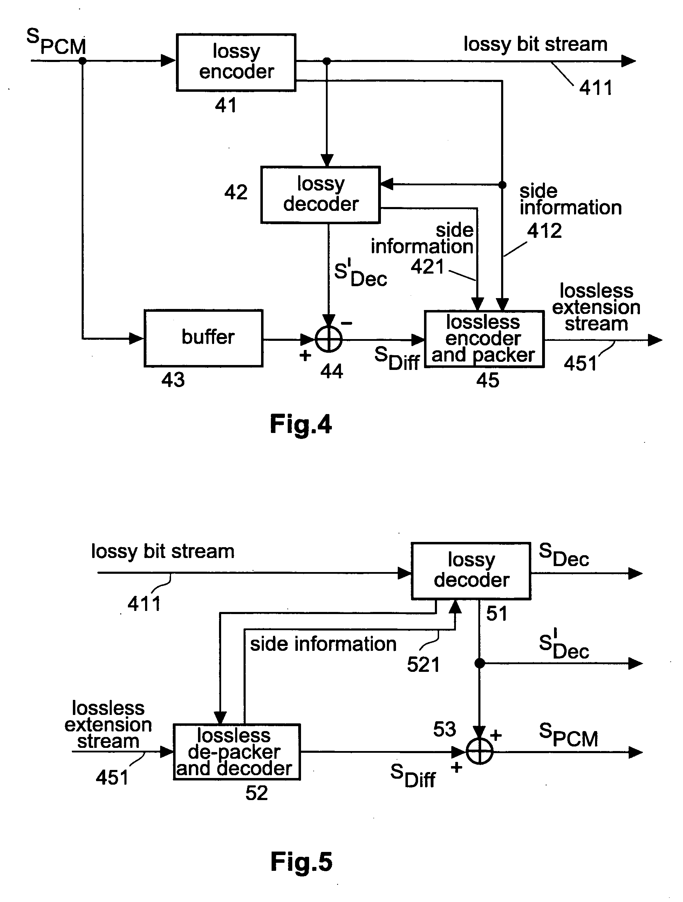

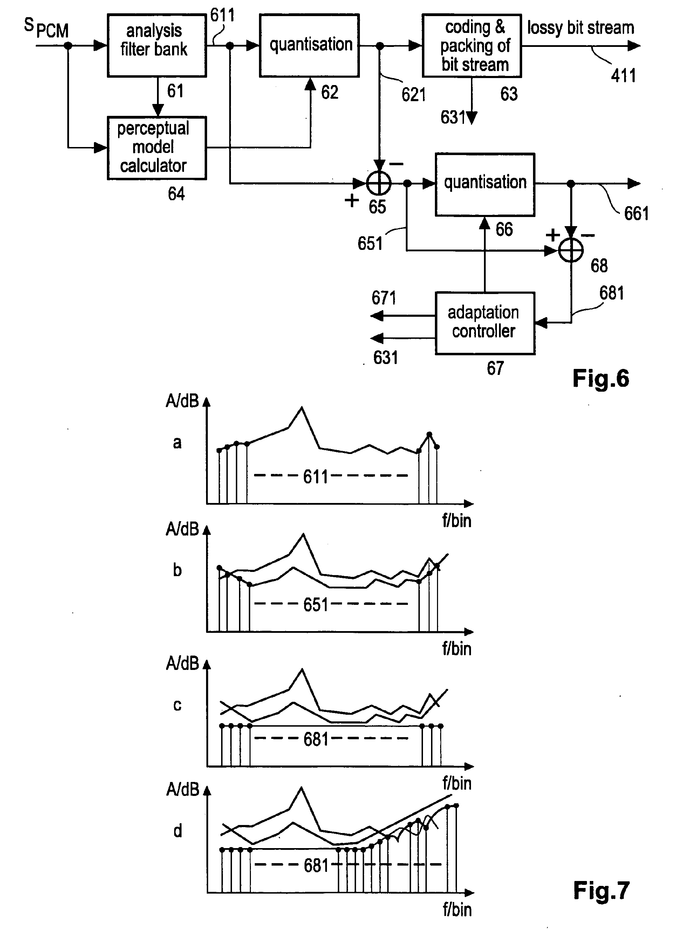

The invention solves the problem of suboptimum de-correlation of lossy based lossless coding by making use of a modified lossy encoder like encoder 41 shown in Fig. 4. Besides of producing from the original input signal S_{PCM} a compliant lossy bit stream 411, this encoder generates special spectral whitening data which is sent, besides other information, as side information 412 to a corresponding modified lossy decoder 42 and to a lossless encoder and packer 45 outputting a lossless extension bit stream. The lossy encoder 41 is shown in more detail in Fig. 6. The spectral whitening data are formed as explained in connection with figures 6 and 7. In the modified lossy decoder 42 the lossy bit stream 411 is decoded and the frequency spectrum for the current frame of the input signal is restored whereby the spectral whitening data from signal 412 is added to the spectrum. Thereafter in decoder 42 a synthesis filter bank is applied, and a time domain error signal S_{Diff} is calculated in a subtractor 44 by subtracting the corresponding decoder 42 output signal S'_{Dec} from the input signal S_{PCM} that has been correspondingly delayed by a buffer 43 in order to compensate for the required processing time in encoder 41 and decoder 42. The error signal S_{Diff} now has a white (i.e. a flat) frequency power spectrum, which is equivalent to having a high de-correlation, and thus is suited for efficient entropy coding. Signal S_{Diff} is fed to a lossless encoder and packer 45 which contains an entropy encoder and includes in its lossless extension stream 451 output lossy encoder side information data 412 provided from encoder 41 and lossy decoder side information data 421 provided by decoder 42.
To increase the lossless coding efficiency, the modified lossy encoder 41 can reduce the amount of whitening data (and thus the related bit rate) in favour of an additional LPC filter placed inside the lossless encoder and packer 45. The LPC filter coefficients are determined using lossy bit stream elements like scale factors or the block spectrum in decoder 42 in the preferred embodiment, and only a very small amount of additional data needs to be transmitted to enable calculation of the filter coefficients at decoder side.

In the lossy based lossless decoding in Fig. 5 the lossy bit stream 411 is decoded in a modified lossy decoder 51 that outputs a (known) lossy encoded and decoded output signal S_{Dec}, e.g. a decoded mp3 signal, which may be denoted as lossy mode 1.
When receiving the lossless extension stream 451, consistency to match the lossy bit stream 411 and a permission check to allow decoding for different modes can be performed, e.g. in a lossless de-packer and decoder 52. The different modes can be the lossy mode 1, a lossy mode 2 and a lossless mode 3.
If not operating in mode 1 only, received spectral whitening data is de-packed in means 52 and is sent (among other information) as side information 521 to the lossy decoder 51, in which spectral whitening data is added to the restored spectrum and a synthesis filter-bank is applied to create the output signal S'_{Dec}. In lossy mode 2 S'_{Dec} is the output signal. This is a lossy signal which is superior to signal S_{Dec} in terms of perceptual quality and is called 'intermediate quality' in the following description. It is not necessary to decode the lossless encoded difference signal S_{Diff}.
In lossless mode 3 the lossless extension stream 451 is further de-packed in means 52 and entropy decoding is applied therein, and an optional LPC synthesis can be applied if signalled correspondingly in the lossless extension bit stream 451. In a preferred embodiment the LPC synthesis filter coefficients are determined using corresponding information items from lossy bit stream 411 data elements like scale factors or the spectrum of related lossy coefficient blocks in sub-band domain of the lossy decoder 51, as well as optional helper information items transmitted inside the lossless extension stream 451. The error signal S_{Diff} is restored in means 52 and is synchronised to signal S'_{Dec}· The error signal S_{Diff} and the signal S'_{Dec} (i.e. the intermediate quality signal) are combined in an adder 53 so as to regain the mathematically lossless reconstruction of the original signal S_{PCM}.

The lossy decoder 51 operates exactly like lossy decoder 42 in the encoding part in terms of calculation of signal S'_{Dec}. Signal S'_{Dec} in the decoding part and signal S'_{Dec} in the encoding part are mathematically identical, as well as signals S_{Diff} in the decoding part and S_{Diff} in the encoding part.
Advantageously, the lossy decoder implementations 51 and 42 and the optional LPC elements in means 52 and means 45 can be realised platform independent using integer arithmetic.

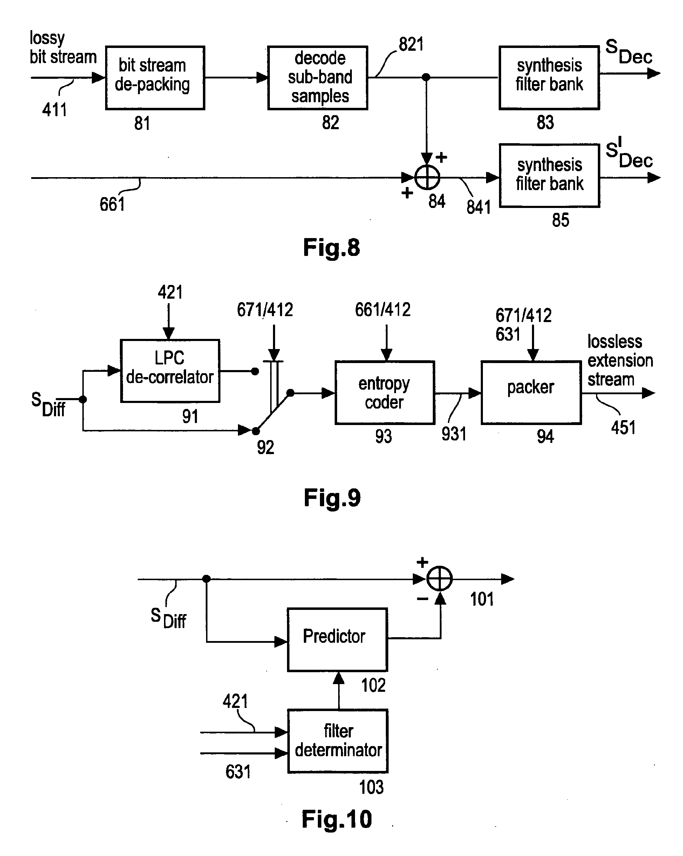

The lossy encoder 41 of Fig. 4 is explained in more detail in connection with Fig. 6. The lossy decoder 51 of Fig. 5 is explained in more detail in connection with Fig. 8. By combining lossy encoder 41 and lossy decoder 42 in Fig. 4, simplifications are feasible.

### Lossy encoder

The lossy encoder 41 includes an analysis filter-bank 61 and a perceptual model calculator 64 which both receive the original input signal S_{PCM}. The output signal of filter bank 61 passes to the first input of a subtractor 65 and through a first quantisation means 62. The output of the quantization means 62 passes to the second input of the subtractor 65 and to an encoding and bit stream packing means 63 that provides the lossy bitstream 411. The analysis filter-bank 61 converts signal S_{PCM} into the sub-band domain.
An example spectrum of signal 611 is depicted in Fig. 7a, showing the amplitudes A of the spectrum versus the frequency f.
Signal 611 is quantised in the first quantiser 62 according to the control of the perceptual model provided by calculator 64. An error signal 651 is calculated by subtracting the quantised sub-band samples 621 from the original sub-band samples 611. Usually the amplitude of this error signal is proportional to the masking thresholds determined in the perceptual model. An example error signal 651 is depicted in Fig. 7b in comparison to signal 611.
The error signal 651 is quantised in a second quantisation means 66 in such a way that a further error signal 681 is calculated within an adaptation control loop formed by a second subtractor 68 and an adaptation controller 67, which further error signal 681 is the difference between signal 651 and the output signal of the second quantiser 66 and approaches a white spectrum, as depicted in Fig. 7c together with signals 611 and 651. The output signal of second quantiser 66 represents spectral whitening data 661 that is sent as part of the side information 412 to lossy decoder 42 and to lossless encoder and packer 45. Adaptation control 67 controls second quantiser 66 and takes care to find the right quantisation and the right bit rate for signal 661. If the bit rate exceeds a pre-determined threshold value and the error spectrum 681 is therefore not estimated 'white', within side information 412 an escape signal 671 is sent indicating that the lossless encoder and packer 45 shall use additional LPC de-correlation. Adaptation control 67 sets the optimum quantisation step for quantiser 66 to enable a flat noise floor, see signal 681 in Fig. 7c. This control may include a power analysis of signal 651. An iterative process is not necessary.
The second task of adaptation control 67 is to observe an estimation of the bit rate of the entropy encoded signal 661. Signal 661 is later entropy coded in step or stage 93. The bit rate of the entropy coded signal 661 is a main contribution to the overall rate of the 'lossless' bit-stream 451. In case this bit rate estimate exceeds a threshold the escape signal 671 to use additional LPC de-correlation in time domain is sent.

Another possibility would be that adaptation control 67 optimises signal 661 such that signal 681 is no longer white (i.e. it uses different quantisation steps over the frequency bin axis). The noise floor 681 is then formed to match the characteristics of a given LPC de-correlator filter out of a dictionary of different LPC filters. The adaptation control process then becomes iterative in order to find the closest match of signal 681 with lowest costs (i.e. share of bit rate). This is depicted in Fig. 7d.

### Lossy decoder

The lossy decoder 42 shown in Fig. 8 receives lossy bit stream 411 which is de-packed in a bit stream depacker 81 and is decoded (including inverse quantiser scale factor processing if applicable) in a sub-band sample decoder 82 to create a sub-band sample signal 821 which is identical to signal 621 in the lossy encoder in Fig. 6. Signal 821 is transformed back to the time domain in a synthesis filter bank 83 that restores in each case a block of data values of signal SDec. The spectral whitening data 661 (which is received from the lossless extension stream following de-packing) is added in a combiner 84 to signal 821, in order to form a signal 841 that has a quantisation error in the sub-band domain which is identical to the quantisation error of signal 681 in figures 6 and 7c. A synthesis filter bank 85 transforms signal 841 back to the time domain and restores in each case a block of data values of signal S'_{Dec}. Because normally either signal S_{Dec} or signal S'_{Dec} is output, a single synthesis filter can be used that is connected to either signal 821 or signal 841, respectively.

The lossy decoder should be realised in a platform independent manner using special integer arithmetic operations. Decoding a given bit stream to signal S'_{Dec} within the lossless decoder at encoding or at decoding side needs to produce numerically equivalent results on every platform like ARM based, Intel Pentium based, or DSP based platforms.

### Buffer and synchronisation

Lossy encoding and decoding induces a delay between the signals S_{PCM} and S'_{Dec} in Fig. 4. When operating the lossless encoder in streaming real-time applications the lossy encoder is aware of this delay and will control First-In First-Out buffering in buffer 43 to guarantee sample-exact (i.e. synchronised) operation at subtractor 44 in Fig. 4. When operating the lossless encoder for file-to-file operations, e.g. converting PCM Audio files to lossless encoded files, the buffer 43 can be replaced by using synchronisation means as described in US-B-6903664.
In the preferred embodiment the lossy encoder will insert information items indicating the coding delay and the original file length into the auxiliary data part of the lossy bit stream of the first one or two audio frames as well as into the first frame of the lossless extension. The lossy decoder 42 and 51 will read this information and skip the first decoded (zero) samples indicated by the delay information.

### Lossless encoder and packer

The lossless encoder and packer 45 of Fig. 4 is shown in more detail in Fig. 9. During regular operation the error signal S_{Diff} is highly de-correlated and can be entropy coded in entropy encoder 93, for which coding the preferred embodiment uses a Golomb-Rice coding. Spectral whitening data 661 (from bus 412) is also entropy coded in encoder 93 using a different entropy coding method, e.g. Huffman coding. The packer 94 forms a frame based bit stream using the entropy coded data 931 and additional information items 412 like escape signal 671 from lossy encoder 41, and outputs the lossless extension stream 451. If indicated by lossy encoder 41 with the escape signal 671, the error signal S_{Diff} can be further de-correlated using a linear prediction in an LPC de-correlator 91, which is shown in more detail in Fig. 10. LPC de-correlator 91 receives helper information from bus 421. The switching according to escape signal 671 (from bus 412) is performed by switch 92.

### LPC de-correlator

In the LPC de-correlator in Fig. 10, from the input signal S_{Diff} a version passed through predictor 102 is subtracted in a subtractor 101. Its output signal is fed to switch 92. Predictor 102 uses a filter that is calculated using a filter determinator 103, the filter coefficients of which are derived from the helper information signal from bus 421. Filter determinator 103 can operate as follows:

### Mode 1

The scale factors of the decoder are transmitted as signal 421 to filter determinator 103. These scale factors si are used to estimate the spectral power of the residual in the transform domain:
*Sₑₑ(i)* = 2^{-3/8*si*}, with *i* = 0,..., *N_{band}*-1 (number of bins), whereby the step-like power estimate may become smoothed.

These spectral power values are duplicated to form an even sequence *S*'*ₑₑ(i)* with *i* =0, ..., *N_{band}* - 1, ..., *2N_{band}* - 1. This is done to enable a real-valued inverse FFT sequence. Thereafter the auto-correlation is calculated by iFFT(*S'ₑₑ*(*i*)). The Levison-Durbin algorithm can be used to determine the LPC coefficients.
This procedure can also be used in the lossless decoder. If relevant parts of the higher frequency spectrum are not transmitted inside the lossy encoder bit stream 411, this missing information 631 is sent,from step/stage 63 in the lossy encoder to packer 94 for transmission, and from de-packer 111 to filter determinator 103.

### Mode 2

A set of LPC filter-coefficients is selected from a directory of LPS filter coefficient sets by adaptation controller 67. Then signal 631 becomes the directory index for the selected set of coefficients and is passed to packer 94 for transmission.

### Side Information

The side information buses 412 and 421 carry data from lossy encoder 41 to lossy decoder 42 and from either one to the lossless encoder and packer 45, and these buses include the following data elements:
- encoded spectral whitening data 661 (sent via bus 412 from encoder 41 to decoder 42 and to encoder/packer 45);
- an escape signal 671 to indicate additional LPC de-correlation (sent via bus 412 from encoder 41 to encoder/packer 45, i.e. indicating that LPC de-correlation and LPC synthesis is active;
- a helper information signal (sent via bus 421 from decoder 42 to encoder/packer 45 or 94, respectively), i.e. scale factors for LPC filter determination;
- a helper information 631 sent from lossy encoder 41 to encoder packer 45/94, for transmitting missing scale factors for high frequency bands or an index to a set of predefined LPC filter coefficients;
- for file-to-file applications, lossy coder delay value and/or original file length value (sent via bus 412 from encoder 41 to decoder 42 and to encoder/packer 45).

### Lossy based lossless decoding

As already described in connection with Fig. 2, the decoding is carried out using a lossy decoder 25 and a lossless decoder 27, the output signals of which are combined to regain the original input signal samples S_{PCM}. Advantageously, the decoding can be carried out in different modes.

### Mode 1

The decoder can decode any compliant lossy bit stream 411 without a lossless extension stream 451 being present, and provides signal S_{Dec}. This mode is also active when a lossless extension stream 451 is present but no permission is provided to use another mode. Preferably, the decoder will check the lossless extension stream for a matching permission ID in its rights data-base.

### Mode 2

This intermediate-quality mode is also enabled by a permission check in the decoder when examining the lossless extension stream data. Only the whitening data 661 is de-packed and used by the lossy decoder to provide signal S'_{Dec}.

### Mode 3

The lossless mode decoding is started following a positive permission check result, and signal S_{PCM} is output.

The corresponding lossy decoder 51 is depicted in Fig. 8 in more detail. The modes of operation are signalled within side information 521 from the lossless de-packer and decoder 52. Basically, the same details apply as described for the lossy decoder 42. The encoded lossy bit stream 411 enters a means 81 for de-packing the bit stream, followed by means 82 for decoding the subband samples and by a synthesis filter bank 83 that outputs the decoded lossy PCM signal S_{Dec}. The output signal 821 from means 82 is combined in an adder 84 with the corresponding spectral whitening data 661. The combined signal 841 enters a second synthesis filter bank 85 that outputs the decoded lossy PCM signal S'_{Dec}.

### Lossless de-packer and decoder

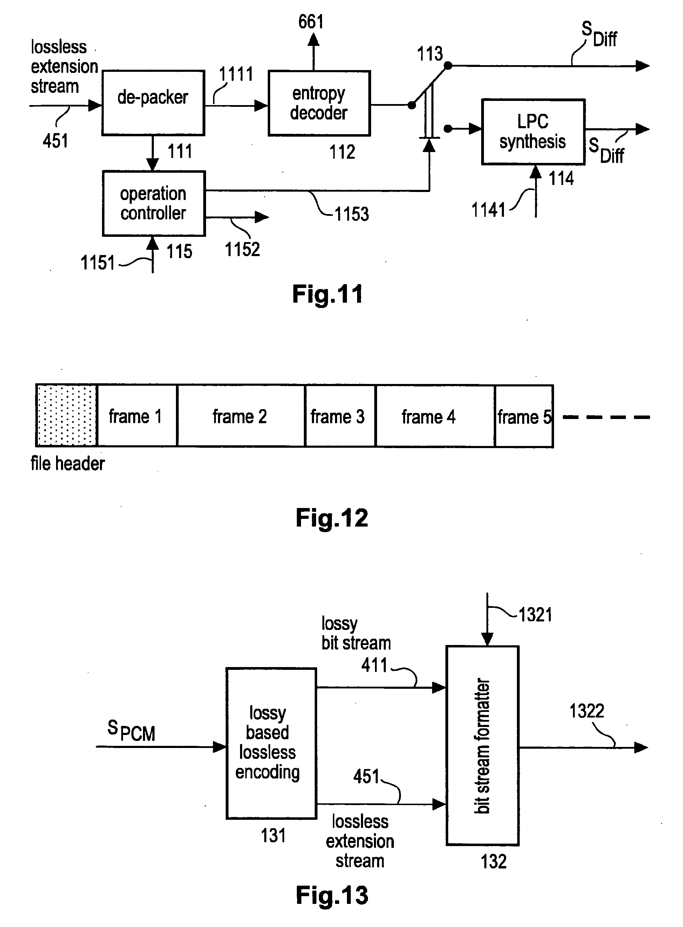

Fig. 11 shows the lossless de-packer and decoder 52 in more detail. The lossless de-packer 111 receives the lossless extension stream 451 which is parsed and de-packed.
Control information is routed to operation controller 115 in which in case of file-to-file applications a consistency check can be performed to identify integrity with respect to the lossy bit stream 411. As an option, a reference fingerprint (e.g. CRC data) is extracted from the lossless extension stream 451 and a current fingerprint is calculated over a certain data block of the lossy bit stream 411. If.both finger prints are identical the normal operation proceeds. A permission check may be performed as a next step to identify the allowed mode or modes of operation. Corresponding information items 1151 received from an external database are used for comparison with permission identifiers of the received bit stream. The current mode is determined and a corresponding signal 1152 is used to send related information to the lossy decoder 51 using the side information channel 521. In special embodiments, means for deciphering an encrypted lossless extension stream might also be used. Following de-packing, the audio extension signal data 1111 is entropy decoded in an entropy decoder 112. The entropy encoded spectral whitening data items are correspondingly entropy decoded, e.g. in encoder 112. The decoded whitening data 661 is sent to the lossy decoder 51 and the difference signal data S_{Diff} is sent to the combiner or summation unit 53. If escape information to apply additional LPC synthesis is identified in the bit stream 451 by de-packer 111 and operation controller 115, that controller will use signal 1153 to switch switcher 113 to the LPC synthesis path. The coefficients of LPC synthesis filter 114 are calculated using helper information 1141 which is provided from de-packer 111, or which can be determined from the lossy bit stream scale-factors or from the decoder sub-band signal 841 and additional information transmitted in the lossless extension bit stream 451 like missing scale-factors or spectral power information of high frequency bands not transmitted in lossy bit stream 411, or an index value pointing to a set of predefined LPC coefficients.

### Side information

The side information 521 exchanged between lossy decoder 51 and lossless de-packer and decoder 52 includes the following information and data elements:
- a mode indicator signal 1152 (sent to decoder 52);
- spectral whitening data 661 (sent to decoder 52);
- helper information 1141 from lossy decoder 42 to determine LPC filter coefficients (sent to lossless de-packer and decoder 52);
- lossy coder delay value and/or original file length value for file-to-file applications (sent to decoder 52).

### Lossless extension bit stream

The following data elements can be provided within the lossless extension bit stream as header data elements:
- a fingerprint to unambiguously identify corresponding lossy bit stream. This element is needed especially for two files applications and might be disregarded for container (one file) and streaming applications;
- mode indicators and corresponding DRM information;
- synchronisation information (lossy coding delay, original file length, file end indicator);
- PCM word size of original signal (16, 20 or 24 bits);
- cue point information enabling a faster addressing of lossless data frames inside the (variable bit rate) stream, consisting of a table of constant frame interval pointers and an frame interval length indicator.

In file-to-file applications these information items need to be provided only once at the beginning of the lossless bit stream. In streaming applications these information items, excluding the cue- point data, need to be sent every N frames.

Frame data elements of the lossless extension bit stream bit stream are:
- a frame boundary indicator to enable frame-synchronous operation for the lossy bit stream;
- coded spectral error (i.e. whitening) data;
- escape information indicating the use of additional LPC synthesis, and LPC helper information;
- the encoded time error signal data.

A lossless extension stream file format is shown in Fig. 12. A file header provides side information to start the process of decoding. Following the header data, data frames of variable length containing data for reconstructing an intermediate-quality audio signal and for reconstructing a lossless-quality audio signal are arranged.
File header data:
- header ID;
- header length;
- fingerprint (e.g. CRC32 data);
- mode indication information block;
- side info: codec delay, original file length, PCM word size, sample rate;
- a cue point table data block: block-length value, interval info in frames, number of table entries, pointer-table.
Frame data:
- sync word (optional) and frame length;
- coded spectral error (i.e. whitening) data: block-length, coded data. This is the data required to decode to intermediate quality (mode 2). Decoders operating in mode 2 will skip the rest of the frame data if such data are present;
- LPC helper information: block length value, LPC mode indicator, coded data;
- coded time error signal: block length value, coded data.

### Bit stream formats and rights management

The lossy bit stream 411 and the lossless extension stream 451 can be formatted for different storage or streaming applications, see Fig. 13. The output signals 411 and 451 of the lossy based lossless encoding 131 are fed to a bit stream formatter 132. The resulting output signal 1322 can be a single stream or file or can consist of two streams or two files. A rights management processing may be applied by supplying formatter 132 with corresponding rights management data 1321.
At decoding side, a corresponding bit stream de-formatter can be used.

## Claims

1. Method for lossless encoding of an audio source signal (S_{PCM}), using a lossy encoded data stream (411) and a lossless extension data stream (451) which together form a lossless encoded data stream (1322) for said source signal, said method including the steps:
- lossy encoding (41) said source signal, wherein said lossy encoding provides said lossy encoded data stream (411) as well as spectral whitening data (661);
- correspondingly lossy decoding (42) said lossy encoded data, thereby reconstructing a standard decoded signal (S_{Dec}) and, using said spectral whitening data, constructing from said standard decoded signal a superior quality decoded signal (S'_{Dec});
- forming (43, 44) a difference signal (S_{Diff}) between said source signal (S_{PCM}) and said superior quality decoded signal (S'_{Dec}) and lossless encoding (45) said difference signal;
- packing said encoded difference signal together with said spectral whitening data (661) to form said lossless extension data stream (451),
wherein said spectral whitening data (661) are generated by:
-- processing said source signal (S_{PCM}) in an analysis filter bank (61) and quantising (62) its output signal and forming (65) the difference signal (651) between the analysis filter bank output signal (611) and the quantisation output signal (621), wherein said quantising is controlled by a perceptual model calculator (64);
-- quantising (66) said difference signal (651) thereby controlling this further quantisation such that the difference signal (681) between the input and the output of said further quantisation approaches a white spectrum, whereby the output signal of said further quantisation forms said spectral whitening data (661), and wherein said further quantisation (66) is controlled by an adaptation controller (67) that checks the current bit rate of said spectral whitening data (661) and, if said current bit rate exceeds a pre-determined threshold value, sets an escape signal (671) ;
and wherein said lossless encoding of said difference signal (S_{Diff}) uses an entropy encoder (93), the input signal of which passes through an LPC de-correlator (91) only if said escape signal (671) is set.

2. Apparatus for lossless encoding of an audio source signal (S_{PCM}), using a lossy encoded data stream (411) and a lossless extension data stream (451) which together form a lossless encoded data stream (1322) for said source signal, said apparatus including:
- means (41) being adapted for lossy encoding said source signal, wherein said lossy encoding provides said lossy encoded data stream (411) as well as spectral whitening data (661);
- means (42) being adapted for correspondingly lossy decoding said lossy encoded data, thereby reconstructing a standard decoded signal (S_{Dec}) and, using said spectral whitening data, for constructing from said standard decoded signal a superior quality decoded signal (S'_{Dec});
- means (43, 44, 45) being adapted for forming a difference signal (S_{Diff}) between said source signal (S_{PCM}) and said superior quality decoded signal (S'_{Dec}) and for lossless encoding said difference signal and for packing said encoded difference signal together with said spectral whitening data (661) to form said lossless extension data stream (451),
wherein said lossy encoding means comprise:
-- means (61, 62) being adapted for processing said source signal (S_{PCM}) in an analysis filter bank and quantising its output signal and forming (65) the difference signal (651) between the analysis filter bank output signal (611) and the quantisation output signal (621),
wherein said quantising is controlled by a perceptual model calculator (64);
-- means (66) being adapted for quantising said difference signal (651) thereby controlling this further quantisation such that the difference signal (681) between the input and the output of said further quantisation approaches a white spectrum, whereby the output signal of said further quantisation forms said spectral whitening data (661),
and wherein said further quantisation (66) is controlled by an adaptation controller (67) that checks the current bit rate of said spectral whitening data (661) and, if said current bit rate exceeds a pre-determined threshold value, sets an escape signal (671);
and wherein in said difference signal forming means said lossless encoding of said difference signal (S_{Diff}) uses an entropy encoder (93), the input signal of which passes through an LPC de-correlator (91) only if said escape signal (671) is set.

3. Method for decoding a lossless encoded audio source signal (S_{PCM}) data stream, which data stream was derived from a lossy encoded data stream (411) and a lossless extension data stream (451) which together form a lossless encoded data stream (1322) for said source signal,
wherein said source signal was lossy encoded (41), said lossy encoding providing said lossy encoded data stream (411) as well as spectral whitening data (661),
and wherein said lossy encoded data were correspondingly lossy decoded (42), thereby reconstructing a standard decoded signal (S_{Dec}) and, using said spectral whitening data, a superior quality decoded signal (S'_{Dec}) was constructed from said standard decoded signal,
and wherein a difference signal (S_{Diff}) between said source signal (S_{PCM}) and said superior quality decoded signal (S'_{Dec}) was formed (43, 44) and lossless encoded (45),
and wherein said lossless encoded difference signal was packed together with said spectral whitening data (661) to form said lossless extension data stream (451),
and wherein said spectral whitening data (661) were generated by:
-- processing said source signal (S_{PCM}) in an analysis filter bank (61) and quantising (62) its output signal and forming (65) the difference signal (651) between the analysis filter bank output signal (611) and the quantisation output signal (621), wherein said quantising was controlled by a perceptual model calculator (64);
-- quantising (66) said difference signal (651) thereby controlling this further quantisation such that the difference signal (681) between the input and the output of said further quantisation approaches a white spectrum, whereby the output signal of said further quantisation forms said spectral whitening data (661), and wherein said further quantisation (66) is controlled by an adaptation controller (67) that checks the current bit rate of said spectral whitening data (661) and, if said current bit rate exceeds a pre-determined threshold value, sets an escape signal (671),
said decoding method including the steps:
- de-packing (52) said lossless extension data stream (451) and decoding (52) said lossless encoded difference signal so as to provide said difference signal (S_{Diff}) and said spectral whitening data (661), wherein said decoding of said lossless encoded difference signal (S_{Diff}) uses an entropy decoder (112), the output signal of which passes through an LPC synthesis (114) only if said escape signal was set at encoding site;
- lossy decoding (51) said lossy encoded data stream (411), thereby reconstructing said standard decoded signal (S_{Dec}) and, using said spectral whitening data, reconstructing (51) said superior quality decoded signal (S'_{Dec}) from said standard decoded signal;
- forming (53) from said decoded lossless encoded difference signal (S_{Diff}) and from said superior quality decoded signal (S'_{Dec}) a reconstructed source signal (S_{PCM}).

4. Apparatus for decoding a lossless encoded audio source signal (S_{PCM}) data stream, which data stream was derived from a lossy encoded data stream (411) and a lossless extension data stream (451) which together form a lossless encoded data stream (1322) for said source signal, wherein said source signal was lossy encoded (41), said lossy encoding providing said lossy encoded data steam (411) as well as spectral whitening data (661),
and wherein said lossy encoded data were correspondingly lossy decoded (42), thereby reconstructing a standard decoded signal (S_{Dec}) and, using said spectral whitening data, a superior quality decoded signal (S'_{Dec}) was constructed from said standard decoded signal,
and wherein a difference signal (S_{Diff}) between said source signal (S_{PCM}) and said superior quality decoded signal (S'_{Dec}) was formed (43, 44) and lossless encoded (45),
and wherein said lossless encoded difference signal was packed together with said spectral whitening data (661) to form said lossless extension data stream (451),
and wherein said spectral whitening data (661) were generated by:
-- processing said source signal (S_{PCM}) in an analysis filter bank (61) and quantising (62) its output signal and forming (65) the difference signal (651) between the analysis filter bank output signal (611) and the quantisation output signal (621), wherein said quantising was controlled by a perceptual model calculator (64);
-- quantising (66) said difference signal (651) thereby controlling this further quantisation such that the difference signal (681) between the input and the output of said further quantisation approaches a white spectrum, whereby the output signal of said further quantisation forms said spectral whitening data (661), and wherein said further quantisation (66) is controlled by an adaptation controller (67) that checks the current bit rate of said spectral whitening data (661) and, if said current bit rate exceeds a pre-determined threshold value, sets an escape signal (671),
said decoding apparatus including:
- means (52) being adapted for de-packing said lossless extension data stream (451) and for decoding said lossless encoded difference signal so as to provide said difference signal (S_{Diff}) and said spectral whitening data (661), wherein said decoding of said lossless encoded difference signal (S_{Diff}) uses an entropy decoder (112), the output signal of which passes through an LPC synthesis (114) only if said escape signal was set at encoding site;
- means (51) being adapted for lossy decoding said lossy encoded data stream (411), thereby reconstructing said standard decoded signal (S_{Dec}) and, using said spectral whitening data, reconstructing (51) said superior quality decoded signal (S'_{Dec}) from said standard decoded signal;
- means (53) being adapted for forming from said decoded lossless encoded difference signal (S_{Diff}) and from said superior quality decoded signal (S'_{Dec}) a reconstructed source signal (S_{PCM}).

5. Method according to the method of claim 1, or apparatus according to the apparatus of claim 2, wherein said spectral whitening data (661) are entropy encoded (93).

6. Method according to the method of claim 3, or apparatus according to the apparatus of claim 4, wherein said spectral whitening data (661) were entropy encoded (93) at encoding site and are entropy decoded (112) at decoding site.

7. Method according to the method of one of claims 1, 3, 5 and 6, or apparatus according to the apparatus of one of claims 2 and 4 to 6, wherein said LPC de-correlator and said LPC synthesis, respectively, are an LPC filter, the filter coefficients of which are determined using information items like scale factors and/or the spectrum of related coefficient blocks in the sub-band domain of said lossy bit stream (411) and/or helper information items.

8. Method according to the method of one of claims 1, 3 and 5 to 7, or apparatus according to the apparatus of one of claims 2 and 4 to 7, wherein said lossless extension data stream (451) includes:
- encoded spectral whitening data (661);
- an escape signal (671) indicating that LPC de-correlation is active;
- a helper information signal;
- for file-to-file applications, a lossy coder delay value and/or an original file length value.

9. Lossless extension bit stream (451) including:
- entropy encoded difference signal (S_{Diff}) data;
- encoded spectral whitening data (661);
- an escape signal (671) indicating that LPC de-correlation is active;
- a helper information signal;
- for file-to-file applications, a lossy coder delay value and/or an original file length value, which data items and signals facilitate carrying out the method according to claim 3.

10. Lossless encoded bit stream (1322), including lossy encoded signal data (411), e.g. mp3 data, and the data items and signals and optional values defined in claim 9.

11. Storage medium, for example on optical disc, that contains or stores, or has recorded on it, a digital video signal encoded according to the method of one of claims 1, 5 and 7 to 8.

12. Storage medium, for example on optical disc, that contains or stores, or has recorded on it, a bit stream according to claim 9 or 10.

## Patentansprüche

1. Verfahren zum verlustfreien Codieren eines Audio-Quellensignals (S_{PCM}) unter Verwendung eines verlustbehaftet codierten Datenstroms (411) und eines verlustfreien Erweiterungsdatenstroms (451), welche zusammen einen verlustfrei codierten Datenstrom (1322) für das Quellensignal ausbilden, wobei das Verfahren die Schritte umfasst:
- verlustbehaftetes Codieren (41) des Quellensignals, wobei das verlustbehaftete Codieren den verlustbehaftet codierten Datenstrom (411) als auch spektrale Weißungsdaten (661) zur Verfügung stellt;
- entsprechend verlustbehaftetes Decodieren (42) der verlustbehaftet codierten Daten, wobei **dadurch** ein standardmäßig decodiertes Signal (S_{DEC}) wiederhergestellt wird und, unter Verwendung der spektralen Weißungsdaten, ausgehend von dem standardmäßig decodierten Signal ein decodiertes Signal höherer Qualität (S'_{Dec}) hergestellt wird;
- Ausbilden (43, 44) eines Differenzsignals (S_{Diff}) zwischen dem Quellensignal (S_{PCM}) und dem decodierten Signal höherer Qualität (S'_{Dec}) und verlustfreies Codieren (45) des Differenzsignals;
- Packen des codierten Differenzsignals zusammen mit den spektralen Weißungsdaten (661) um den verlustfreien Erweiterungsdatenstrom (451) auszubilden,
wobei die spektralen Weißungsdaten (661) erzeugt werden durch:
-- Verarbeiten des Quellensignals (S_{PCM}) in einer Analysefilterbank (61) und Quantisieren (62) ihres Ausgangssignals und Ausbilden (65) des Differenzsignals (651) zwischen dem Analysefilterbank-Ausgangssignal (611) und dem Quantisierungs-Ausgangssignal (621), wobei das Quantisieren durch einen Wahrnehmungsmodell-Rechner (64) gesteuert wird;
-- Quantisieren (66) des Differenzsignals (651), wobei diese weitere Quantisierung dergestalt gesteuert wird dass sich das Differenzsignal (681) zwischen dem Eingang und dem Ausgang der weiteren Quantisierung einem Weißspektrum annähert, wodurch das Ausgangssignal der weiteren Quantisierung die spektralen Weißungsdaten (661) ausbildet, und wobei die weitere Quantisierung (66) durch eine Anpassungssteuereinheit (67) gesteuert wird welche die aktuelle Bitrate der spektralen Weißungsdaten (661) prüft und, wenn die aktuelle Bitrate einen vorbestimmten Schwellenwert übersteigt, ein Austrittssignal (671) setzt;
und wobei für das verlustfreie Codieren des Differenzsignals (S_{Diff}) ein Entropie-Codierer (93) verwendet wird, dessen Eingangssignal nur dann durch einen LPC-Dekorrelator (91) hindurchgeht wenn das Austrittssignal (671) gesetzt ist.

2. Vorrichtung zum verlustfreien Codieren eines Audio-Quellensignals (S_{PCM}) unter Verwendung eines verlustbehaftet codierten Datenstroms (411) und eines verlustfreien Erweiterungsdatenstroms (451), welche zusammen einen verlustfrei codierten Datenstrom (1322) für das Quellensignal ausbilden, wobei die Vorrichtung umfasst:
- Mittel (41) die zum verlustbehafteten Codieren des Quellensignals eingerichtet sind, wobei das verlustbehaftete Codieren den verlustbehaftet codierten Datenstrom (411) als auch spektrale Weißungsdaten (661) zur Verfügung stellt;
- Mittel (42) die zum entsprechend verlustbehafteten Decodieren der verlustbehaftet codierten Daten eingerichtet sind,
wobei **dadurch** ein standardmäßig decodiertes Signal (S_{Dec}) wiederhergestellt wird und, unter Verwendung der spektralen Weißungsdaten, zum Herstellen eines decodierten Signals höherer Qualität (S'_{Dec}) ausgehend von dem standardmäßig decodierten Signal;
- Mittel (43, 44, 45) die zum Ausbilden eines Differenzsignals (S_{Diff}) zwischen dem Quellensignal (S_{PCM}) und dem decodierten Signal höherer Qualität (S'_{Dec}) und zum verlustfreien Codieren des Differenzsignals und zum Packen des codierten Differenzsignals zusammen mit den spektralen Weißungsdaten (661) eingerichtet sind, um den verlustfreien Erweiterungsdatenstrom (451) auszubilden,
wobei die verlustbehafteten Codierungsmittel umfassen:
-- Mittel (61, 62) die zum Verarbeiten des Quellensignals (S_{PCM}) in einer Analysefilterbank und Quantisieren ihres Ausgangssignals und zum Ausbilden (65) des Differenzsignals (651) zwischen dem Analysefilterbank-Ausgangssignal (611) und dem Quantisierungs-Ausgangssignal (621) eingerichtet sind, wobei das Quantisieren durch einen Wahrnehmungsmodell-Rechner (64) gesteuert wird;
-- Mittel (66) die zum Quantisieren des Differenzsignals (651) eingerichtet sind, wobei **dadurch** diese weitere Quantisierung dergestalt gesteuert wird dass sich das Differenzsignal (681) zwischen dem Eingang und dem Ausgang der weiteren Quantisierung einem Weißspektrum annähert, wodurch das Ausgangssignal der weiteren Quantisierung die spektralen Weißungsdaten (661) ausbildet, und wobei die weitere Quantisierung (66) durch eine Anpassungssteuereinheit (67) gesteuert wird, welche die aktuelle Bitrate der spektralen Weißungsdaten (661) prüft, und, wenn die aktuelle Bitrate einen vorbestimmten Schwellenwert übersteigt, ein Austrittssignal (671) setzt;
und wobei, bei den das Differenzsignal ausbildenden Mitteln, für das verlustfreie Codieren des Differenzsignals (S_{Diff}) ein Entropie-Codierer (93) verwendet wird, dessen Eingangssignal nur dann durch einen LPC-Dekorrelator (91) hindurchgeht wenn das Austrittssignal (671) gesetzt ist.

3. Verfahren zum Decodieren eines Datenstroms eines verlustfrei codierten Audio-Quellensignals (S_{PCM}), wobei der Datenstrom von einem verlustbehaftet codierten Datenstrom (411) und einem verlustfreien Erweiterungsdatenstrom (451) abgeleitet wird, welche zusammen einen verlustfrei codierten Datenstrom (1322) für das Quellensignal ausbilden,
wobei das Quellensignal verlustbehaftet codiert wurde (41) und das verlustbehaftete Codieren den verlustbehaftet codierten Datenstrom (411) als auch spektrale Weißungsdaten (661) zur Verfügung stellt,
und wobei die verlustbehaftet codierten Daten entsprechend verlustbehaftet decodiert (42) wurden und **dadurch** ein standardmäßig decodiertes Signal (S_{Dec}) wiederhergestellt wird und, unter Verwendung der spektralen Weißungsdaten, ausgehend von dem standardmäßig decodierten Signal ein decodiertes Signal höherer Qualität (S'_{Dec}) hergestellt wurde,
und wobei ein Differenzsignal (S_{Diff}) zwischen dem Quellensignal (S_{PCM}) und dem decodierten Signal höherer Qualität (S'_{Dec}) ausgebildet (43, 44) und verlustfrei codiert (45) wurde,
und wobei das verlustfrei codierte Differenzsignal zusammen mit den spektralen Weißungsdaten (661) gepackt wurde um den verlustfreien Erweiterungsdatenstrom (451) auszubilden,
und wobei die spektralen Weißungsdaten (661) erzeugt wurden durch:
-- Verarbeiten des Quellensignals (S_{PCM}) in einer Analysefilterbank (61) und Quantisieren (62) ihres Ausgangssignals und Ausbilden (65) des Differenzsignals (651) zwischen dem Analysefilterbank-Ausgangssignal (611) und dem Quantisierungs-Ausgangssignal (621), wobei das Quantisieren durch einen Wahrnehmungsmodell-Rechner (64) gesteuert wurde;
-- Quantisieren (66) des Differenzsignals (651), wobei **dadurch** diese weitere Quantisierung dergestalt gesteuert wurde dass sich das Differenzsignal (681) zwischen dem Eingang und dem Ausgang der weiteren Quantisierung einem Weißspektrum annähert, wodurch das Ausgangssignal der weiteren Quantisierung die spektralen Weißungsdaten (661) ausbildet, und wobei die weitere Quantisierung (66) durch eine Anpassungssteuereinheit (67) gesteuert wird, welche die aktuelle Bitrate der spektralen Weißungsdaten (661) prüft und, wenn die aktuelle Bitrate einen vorbestimmten Schwellenwert übersteigt, ein Austrittssignal (671) setzt,
wobei das Decodierungsverfahren die Schritte umfasst:
- Entpacken (52) des verlustfreien Erweiterungsdatenstroms (451) und Decodieren (52) des verlustfrei codierten Differenzsignals dergestalt dass das Differenzsignal (S_{Diff}) und die spektralen Weißungsdaten (661) zur Verfügung gestellt werden, wobei für das Decodieren des verlustfrei codierten Differenzsignals (S_{Diff}) ein Entropie-Decodierer (112) verwendet wird dessen Ausgangssignal nur dann durch eine LPC-Synthese (114) hindurchgeht wenn das Austrittssignal auf der Codierungs-Seite gesetzt wurde;
- verlustbehaftetes Decodieren (51) des verlustbehaftet codierten Datenstroms (411), wobei **dadurch** das standardmäßig decodierte Signal (S_{Dec}) wiederhergestellt wird und, unter Verwendung der spektralen Weißungsdaten, ausgehend von dem standardmäßig decodierten Signal ein decodiertes Signal höherer Qualität (S'_{Dec}) wiederhergestellt wird;
- Ausbilden (53) eines wiederhergestellten Quellensignals (S_{PCM}), ausgehend von dem decodierten verlustfrei codierten Differenzsignal (S_{Diff}) und von dem decodierten Signal höherer Qualität (S'_{Dec}).

4. Vorrichtung zum Decodieren eines Datenstroms eines verlustfrei codierten Audio-Quellensignals (S_{PCM}), wobei der Datenstrom von einem verlustbehaftet codierten Datenstrom (411) und einem verlustfreien Erweiterungsdatenstrom (451) abgeleitet wird, welche zusammen einen verlustfrei codierten Datenstrom (1322) für das Quellensignal ausbilden,
wobei das Quellensignal verlustbehaftet codiert wurde (41) und das verlustbehaftete Codieren den verlustbehaftet codierten Datenstrom (411) als auch spektrale Weißungsdaten (661) zur Verfügung stellt,
und wobei die verlustbehaftet codierten Daten entsprechend verlustbehaftet decodiert (42) wurden und **dadurch** ein standardmäßig decodiertes Signal (S_{Dec}) wiederhergestellt wird und, unter Verwendung der spektralen Weißungsdaten, ausgehend von dem standardmäßig decodierten Signal ein decodiertes Signal höherer Qualität (S'Dec) hergestellt wurde,
und wobei ein Differenzsignal (S_{Diff}) zwischen dem Quellensignal (S_{PCM}) und dem decodierten Signal höherer Qualität (S'_{Dec}) ausgebildet (43, 44) und verlustfrei codiert (45) wurde,
und wobei das verlustfrei codierte Differenzsignal zusammen mit den spektralen Weißungsdaten (661) gepackt wurde um den verlustfreien Erweiterungsdatenstrom (451) auszubilden,
und wobei die spektralen Weißungsdaten (661) erzeugt wurden durch:
-- Verarbeiten des Quellensignals (S_{PCM}) in einer Analysefilterbank (61) und Quantisieren (62) ihres Ausgangssignals und Ausbilden (65) des Differenzsignals (651) zwischen dem Analysefilterbank-Ausgangssignal (611) und dem Quantisierungs-Ausgangssignal (621), wobei das Quantisieren durch einen Wahrnehmungsmodell-Rechner (64) gesteuert wurde;
-- Quantisieren (66) des Differenzsignals (651), wobei **dadurch** diese weitere Quantisierung dergestalt gesteuert wurde, dass sich das Differenzsignal (681) zwischen dem Eingang und dem Ausgang der weiteren Quantisierung einem Weißspektrum annähert, wodurch das Ausgangssignal der weiteren Quantisierung die spektralen Weißungsdaten (661) ausbildet, und wobei die weitere Quantisierung (66) durch eine Anpassungssteuereinheit (67) gesteuert wird, welche die aktuelle Bitrate der spektralen Weißungsdaten (661) prüft und, wenn die aktuelle Bitrate einen vorbestimmten Schwellenwert übersteigt, ein Austrittssignal (671) setzt,
wobei die Decodierungsvorrichtung umfasst:
- Mittel (52) die zum Entpacken des verlustfreien Erweiterungsdatenstroms (451) und zum Decodieren des verlustfrei codierten Differenzsignals dergestalt eingerichtet sind dass das Differenzsignal (S_{Diff}) und die spektralen Weißungsdaten (661) zur Verfügung gestellt werden, wobei für das Decodieren des verlustfrei codierten Differenzsignals (S_{Diff}) ein Entropie-Decodierer (112) verwendet wird dessen Ausgangssignal nur dann durch eine LPC-Synthese (114) hindurchgeht wenn das Austrittssignal auf der Codierungs-Seite gesetzt wurde;
- Mittel (51) die zum verlustbchafteten Decodieren des verlustbehaftet codierten Datenstroms (411) eingerichtet sind,
wobei **dadurch** das standardmäßig decodierte Signal (S_{Dec}) wiederhergestellt wird und, unter Verwendung der spektralen Weißungsdaten, ausgehend von dem standardmäßig decodierten Signal ein decodiertes Signal höherer Qualität (S'_{Dec}) wiederhergestellt (51) wird;
- Mittel (53) die, ausgehend von dem decodierten verlustfrei codierten Differenzsignal (S_{Diff}) und von dem decodierten Signal höherer Qualität (S'_{Dec}), zum Ausbilden eines wiederhergestellten Quellensignals (S_{PCM}) eingerichtet sind.

5. Verfahren nach dem Verfahren von Anspruch 1, oder Vorrichtung nach der Vorrichtung von Anspruch 2, wobei die spektralen Weißungsdaten (661) Entropie-codiert (93) sind.

6. Verfahren nach dem Verfahren von Anspruch 3, oder Vorrichtung nach der Vorrichtung von Anspruch 4, wobei die spektralen Weißungsdaten (661) auf der Codierungs-Seite Entropie-codiert wurden (93) und auf der Decodierungs-Seite Entropie-decodiert (112) werden.

7. Verfahren nach dem Verfahren von einem der Ansprüche 1, 3, 5 und 6, oder Vorrichtung nach der Vorrichtung von einem der Ansprüche 2 und 4 bis 6, wobei der LPC-Dekorrelator bzw. die LPC-Synthese jeweils aus einem LPC-Filter bestehen, dessen Filterkoeffizienten bestimmt werden unter Verwendung von Informationsangaben, wie zum Beispiel Skalierungsfaktoren und/oder das Spektrum von verbundenen Koeffizientenblöcken in der Teilband-Ebene des verlustbehafteten Bitstroms (411) und/oder von Hilfsinformations-Angaben.

8. Verfahren nach dem Verfahren von einem der Ansprüche 1, 3 und 5 bis 7, oder Vorrichtung nach der Vorrichtung von einem der Ansprüche 2 und 4 bis 7, wobei der verlustfreie Erweiterungsdatenstrom (451) umfasst:
- codierte spektrale Weißungsdaten (661);
- ein Austrittssignal (671) welches anzeigt dass die LPC-Dekorrelation aktiv ist;
- ein Hilfsinformations-Signal;
- für Datei-zu-Datei Anwendungen, einen Wert für die Verzögerung des verlustbehafteten Codierers und/oder einen Wert für die Originaldatei-Länge.

9. Verlustfreier Erweiterungsdatenstrom (451), umfassend:
- Daten des Entropie-codierten Differenzsignals (S_{Diff});
- codierte spektrale Weißungsdaten (661);
- ein Austrittssignal (671) welches anzeigt dass die LPC-Dekorrelation aktiv ist;
- ein Hilfsinformations-Signal;
- für Datei-zu-Datei Anwendungen, einen Wert für die Verzögerung des verlustbehafteten Codierers und/oder einen Wert für die Originaldatei-Länge,
wobei die Dateiangaben und Signale das Ausführen des Verfahrens nach Anspruch 3 unterstützen.

10. Verlustfrei codierter Bitstrom (1322) umfassend verlustbehaftet codierte Signaldaten (411), z.B. mp3-Daten, und die Dateien und Signale und optionale Werte die in Anspruch 9 definiert sind.

11. Speichermedium, zum Beispiel eine optische Platte, auf dem ein digitales Videosignal enthalten oder gespeichert ist oder darauf aufgezeichnet ist das gemäß dem Verfahren von einem der Ansprüche 1, 5 und 7 bis 8 codiert ist.

12. Speichermedium, zum Beispiel eine optische Platte, auf dem ein Bitstrom nach Anspruch 9 oder 10 enthalten oder gespeichert ist oder darauf aufgezeichnet ist.

## Revendications

1. Procédé pour le codage sans perte d'un signal audio source (S_{PCM}), à l'aide d'un flux de données codées avec perte (411) et d'un flux de données d'extension sans perte (451) qui forment ensemble un flux de données codées sans perte (1322) pour ledit signal source, ledit procédé incluant les étapes suivantes :
- codage avec perte (41) dudit signal source, où ledit codage avec perte fournit ledit flux de données codées avec perte (411) ainsi que des données de blanchiment spectral (661) ;
- en conséquence, décodage avec perte (42) desdites données codées avec perte, reconstruisant ainsi un signal décodé standard (S_{Dec}) et, à l'aide desdites données de blanchiment spectral, construction, à partir dudit signal décodé standard, d'un signal décodé de qualité supérieure (S'_{Dec}) ;
- formation (43, 44) d'un signal de différence (S_{Diff}) entre ledit signal source (S_{PCM}) et ledit signal décodé de qualité supérieure (S'_{Dec}) et codage sans perte (45) dudit signal de différence ;
- compactage dudit signal de différence codé avec lesdites données de blanchiment spectral (661) afin de former ledit flux de données d'extension sans perte (451),
où lesdites données de blanchiment spectral (661) sont générées par:
-- le traitement dudit signal source (S_{PCM}) dans un banc de filtrage d'analyse (61) et la quantification (62) de son signal de sortie et la formation (65) du signal de différence (651) entre le signal de sortie (611) du banc de filtrage d'analyse et le signal de sortie (621) de la quantification, où ladite quantification est commandée par un calculateur (64) de modèle perceptuel ;
-- la quantification (66) dudit signal de différence (651), commandant ainsi cette quantification supplémentaire de sorte que le signal de différence (681) entre l'entrée et la sortie de ladite quantification supplémentaire approche un spectre blanc, où le signal de sortie de ladite quantification supplémentaire forme lesdites données de blanchiment spectral (661),
et où ladite quantification supplémentaire (66) est commandée par un contrôleur d'adaptation (67) qui vérifie le débit binaire actuel desdites données de blanchiment spectral (661) et, si ledit débit binaire actuel dépasse une valeur de seuil prédéterminée, définit un signal d'échappement (671) ;
et où ledit codage sans perte dudit signal de différence (S_{Diff}) utilise un codage entropique (93) dont le signal d'entrée transite via un décorrélateur LPC (91) uniquement si ledit signal d'échappement (671) est défini.

2. Appareil pour le codage sans perte d'un signal audio source (S_{PCM}), à l'aide d'un flux de données codées avec perte (411) et d'un flux de données d'extension sans perte (451) qui forment ensemble un flux de données codées sans perte (1322) pour ledit signal source, ledit appareil incluant :
- un moyen (41) adapté pour coder avec perte ledit signal source, où ledit codage avec perte fournit ledit flux de données codées avec perte (411) ainsi que des données de blanchiment spectral (661) ;
- un moyen (42) adapté pour décoder avec perte, en conséquence, lesdites données codées avec perte, reconstruisant ainsi un signal décodé standard (S_{Dec}) et, à l'aide desdites données de blanchiment spectral, pour construire, à partir dudit signal décodé standard, un signal décodé de qualité supérieure (S'_{Dec}) ;
- un moyen (43, 44, 45) adapté pour former un signal de différence (S_{Diff}) entre ledit signal source (S_{PCM}) et ledit signal décodé de qualité supérieure (S'_{Dec}) et pour coder sans perte ledit signal de différence et pour compacter ledit signal de différence codé avec lesdites données de blanchiment spectral (661) afin de former ledit flux de données d'extension sans perte (451),
où ledit moyen de codage avec perte comprend :
-- un moyen (61, 62) adapté pour traiter ledit signal source (S_{PCM}) dans un banc de filtrage d'analyse et quantifier son signal de sortie et former (65) le signal de différence (651) entre le signal de sortie (611) du banc de filtrage d'analyse et le signal de sortie (621) de la quantification, où ladite quantification est commandée par un calculateur (64) de modèle perceptuel ;
-- un moyen (66) adapté pour quantifier ledit signal de différence (651), commandant ainsi cette quantification supplémentaire de sorte que le signal de différence (681) entre l'entrée et la sortie de ladite quantification supplémentaire approche un spectre blanc, où le signal de sortie de ladite quantification supplémentaire forme lesdites données de blanchiment spectral (661),
et où ladite quantification supplémentaire (66) est commandée par un contrôleur d'adaptation (67) qui vérifie le débit binaire actuel desdites données de blanchiment spectral (661) et, si ledit débit binaire actuel dépasse une valeur de seuil prédéterminée, définit un signal d'échappement (671) ;
et où dans ledit moyen de formation du signal de différence, ledit codage sans perte dudit signal de différence (S_{Diff}) utilise un codage entropique (93), dont le signal d'entrée transite via un décorrélateur LPC (91) uniquement si ledit signal d'échappement (671) est défini.

3. Procédé pour le décodage d'un flux de données d'un signal audio source codé sans perte (S_{PCM}), lequel flux de données a été dérivé d'un flux de données codées avec perte (411) et d'un flux de données d'extension sans perte (451) qui forment ensemble un flux de données codées sans perte (1322) pour ledit signal source,
où ledit signal source a été codé avec perte (41), ledit codage avec perte fournissant ledit flux de données codées avec perte (411) ainsi que des données de blanchiment spectral (661) ;
et où lesdites données codées avec perte ont été décodées avec perte (42) en conséquence, reconstruisant ainsi un signal décodé standard (S_{Dec}) et, à l'aide desdites données de blanchiment spectral, un signal décodé de qualité supérieure (S'_{Dec}) a été construit à partir dudit signal décodé standard,
et où un signal de différence (S_{Diff}) entre ledit signal source (S_{PCM}) et ledit signal décodé de qualité supérieure (S'_{Dec}) a été formé (43, 44) et codé sans perte (45),
et où ledit signal de différence codé sans perte a été compacté avec lesdites données de blanchiment spectral (661) afin de former ledit flux de données d'extension sans perte (451),
et où lesdites données de blanchiment spectral (661) ont été générées par :
-- le traitement dudit signal source (S_{PCM}) dans un banc de filtrage d'analyse (61) et la quantification (62) de son signal de sortie et la formation (65) du signal de différence (651) entre le signal de sortie (611) du banc de filtrage d'analyse et le signal de sortie (621) de la quantification, où ladite quantification a été commandée par un calculateur (64) de modèle perceptuel ;
-- la quantification (66) dudit signal de différence (651), commandant ainsi cette quantification supplémentaire dé sorte que le signal de différence (681) entre l'entrée et la sortie de ladite quantification supplémentaire approche un spectre blanc, où le signal de sortie de ladite quantification supplémentaire forme lesdites données de blanchiment spectral (661),
et où ladite quantification supplémentaire (66) est commandée par un contrôleur d'adaptation (67) qui vérifie le débit binaire actuel desdites données de blanchiment spectral (661) et, si ledit débit binaire actuel dépasse une valeur de seuil prédéterminée, définit un signal d'échappement (671),
ledit procédé de décodage incluant les étapes suivantes :
- décompactage (52) dudit flux de données d'extension sans perte (451) et décodage (52) dudit signal de différence codé sans perte de sorte à fournir ledit signal de différence (S_{Diff}) et lesdites données de blanchiment spectral (661), où ledit décodage dudit signal de différence codé sans perte (S_{Diff}) utilise un décodage entropique (112) dont le signal de sortie transite via une synthèse LPC (114) uniquement si ledit signal d'échappement a été défini sur le site de codage.
- décodage avec perte (51) dudit flux de données codées avec perte (411), reconstruisant ainsi ledit signal décodé standard (S_{Dec}) et, à l'aide desdites données de blanchiment spectral, reconstruction (51) dudit signal décodé de qualité supérieure (S'_{Dec}) à partir dudit signal décodé standard ;
- formation (53), à partir dudit signal de différence codé sans perte décodé (S_{Diff}) et à partir dudit signal décodé de qualité supérieure (S'_{Dec}), d'un signal source reconstruit (S_{PCM}).

4. Appareil pour le décodage d'un flux de données d'un signal audio source codé sans perte (S_{PCM}), lequel flux de données a été dérivé d'un flux de données codées avec perte (411) et d'un flux de données d'extension sans perte (451) qui forment ensemble un flux de données codées sans perte (1322) pour ledit signal source,
où ledit signal source a été codé avec perte (41), ledit codage avec perte fournissant ledit flux de données codées avec perte (411) ainsi que des données de blanchiment spectral (661) ;
et où lesdites données codées avec perte ont été décodées avec perte (42) en conséquence, reconstruisant ainsi un signal décodé standard (S_{Dec}) et, à l'aide desdites données de blanchiment spectral, un signal décodé de qualité supérieure (S'_{Dec}) a été construit à partir dudit signal décodé standard,
et où un signal de différence (S_{Diff}) entre ledit signal source (S_{PCM}) et ledit signal décodé de qualité supérieure (S'_{Dec}) a été formé (43, 44) et codé sans perte (45),
et où ledit signal de différence codé sans perte a été compacté avec lesdites données de blanchiment spectral (661) afin de former ledit flux de données d'extension sans perte (451),
et où lesdites données de blanchiment spectral (661) ont été générées par :
-- le traitement dudit signal source (S_{PCM}) dans un banc de filtrage d'analyse (61) et la quantification (62) de son signal de sortie et la formation (65) du signal de différence (651) entre le signal de sortie (611) du banc de filtrage d'analyse et le signal de sortie (621) de la quantification, où ladite quantification a été commandée par un calculateur (64) de modèle perceptuel ;
-- la quantification (66) dudit signal de différence (651), commandant ainsi cette quantification supplémentaire de sorte que le signal de différence (681) entre l'entrée et la sortie de ladite quantification supplémentaire approche un spectre blanc, où le signal de sortie de ladite quantification supplémentaire forme lesdites données de blanchiment spectral (661),
et où ladite quantification supplémentaire (66) est commandée par un contrôleur d'adaptation (67) qui vérifie le débit binaire actuel desdites données de blanchiment spectral (661) et, si ledit débit binaire actuel dépasse une valeur de seuil prédéterminée, définit un signal d'échappement (671),
ledit appareil de décodage incluant :
- un moyen (52) adapté pour décompacter ledit flux de données d'extension sans perte (451) et pour décoder ledit signal de différence codé sans perte de sorte à fournir ledit signal de différence (S_{Diff}) et lesdites données de blanchiment spectral (661), où ledit décodage dudit signal de différence codé sans perte (S_{Diff}) utilise un décodage entropique (112) dont le signal de sortie transite via une synthèse LPC (114) uniquement si ledit signal d'échappement a été défini sur le site de codage.
- un moyen (51) adapté pour décoder avec perte ledit flux de données codées avec perte (411), reconstruisant ainsi ledit signal décodé standard (S_{Dec}) et, à l'aide desdites données de blanchiment spectral, reconstruction (51) dudit signal décodé de qualité supérieure (S'_{Dec}) à partir dudit signal décodé standard ;
- un moyen (53) adapté pour former, à partir dudit signal de différence codé sans perte décodé (S_{Diff}) et à partir dudit signal décodé de qualité supérieure (S'_{Dec}), un signal source reconstruit (S_{PCM}).

5. Procédé selon la revendication 1, ou appareil selon la revendication 2, où lesdites données de blanchiment spectral (661) font l'objet d'un codage entropique (93).

6. Procédé selon la revendication 3, ou appareil selon la revendication 4, où lesdites données de blanchiment spectral (661) ont fait l'objet d'un codage entropique (93) sur le site de codage et font l'objet d'un décodage entropique (112) sur le site de décodage.

7. Procédé selon une des revendications 1, 3, 5 et 6, ou appareil selon une des revendications 2 et 4 à 6, où ledit décorrélateur LPC et ladite synthèse LPC, respectivement, constituent un filtre LPC, dont les coefficients de filtrage sont déterminés à l'aide d'éléments d'informations, tels que des facteurs d'échelle et/ou le spectre de blocs de coefficient associés dans le domaine de sous-bande dudit train de bits avec perte (411) et/ou des éléments d'informations de l'assistant.

8. Procédé selon une des revendications 1, 3 et 5 à 7, ou appareil selon une des revendications 2 et 4 à 7, où ledit flux de données d'extension sans perte (451) inclut :
- des données de blanchiment spectral codées (661) ;
- un signal d'échappement (671) indiquant qu'une décorrélation LPC est active ;
- un signal d'informations de l'assistant ;
- pour des applications fichier à fichier, une valeur de retard du codeur avec perte et/ou une valeur de longueur du fichier d'origine.

9. Train de bits d'extension sans perte (451) incluant :
- des données d'un signal de différence (S_{Diff}) soumis à un codage entropique ;
- des données de blanchiment spectral codées (661) ;
- un signal d'échappement (671) indiquant qu'une décorrélation LPC est active ;
- un signal d'informations de l'assistant ;
- pour des applications fichier à fichier, une valeur de retard du codeur avec perte et/ou une valeur de longueur du fichier d'origine,
dont les éléments de données et les signaux facilitent la mise en oeuvre du procédé selon la revendication 3.

10. Train de bits codé sans perte (1322), incluant des données (411) d'un signal codé avec perte, par exemple des données mp3, ainsi que les éléments de données, les signaux et les valeurs optionnelles définies dans la revendication 9.

11. Support de stockage, par exemple un disque optique, qui contient ou stocke ou a enregistré un signal vidéo numérique codé selon le procédé d'une des revendications 1, 5 et 7 à 8.

12. Support de stockage, par exemple un disque optique, qui contient ou stocke ou a enregistré un train de bits selon la revendication 9 ou 10.
